# EUROPEAN PATENT SPECIFICATION

(11) **EP 2 023 276 B1**
(45) Date of publication and mention of the grant of the patent: **21.03.2012**
(21) Application number: 08159801.3
(22) Date of filing: 07.07.2008
(51) Int. Cl.: G06K 19/077, H01L 21/00, H01L 27/00, H01Q 1/00, H05K 1/00

(54) **Manufacturing method for RFID tags**
Herstellungsverfahren für RFID-Etiketten
Procédé de fabrication des étiquettes RFID

(30) Priority: 25.07.2007 JP 2007193305
(43) Date of publication of application: 11.02.2009
(73) Proprietor: OKI PRINTED CIRCUITS CO., LTD., Joetsu-shi, Niigata (JP)
(72) Inventor: Fujimaki, Noboru, Joetsu-shi Niigata (JP); Iinaga, Hiroshi, Joetsu-shi Niigata (JP); Koike, Kiyoshi, Joetsu-shi Niigata (JP)
(74) Representative: Betten & Resch

(56) References cited:
- US-A- 5 854 480
- US-A- 6 027 027
- US-A- 6 100 804
- US-A1- 2001 053 675
- US-A1- 2005 199 734
- US-A1- 2006 010 685
- US-A1- 2006 043 178
- US-B1- 6 181 001
- US-B1- 6 378 774
- US-B1- 7 168 623

## Description

### BACKGROUND OF THE INVENTION

### Field of the Invention

The present invention relates to a radio frequency identification (RFID) tag, and, more in particular, to an RFID tag for transmitting and receiving information to and from an information reading/rewriting device in a noncontact manner. The present invention also relates to an RFID system and its manufacturing method for such an RFID tag.

### Description of the Background Art

In recent years, a radio frequency identifier, i.e. an RFID tag is extensively used not only as a technique for identification and management of commercial products but also as a basic technique for promoting a ubiquitous society. As it uses an electro-magnetic induction field or radiated electro-magnetic waves for communication with an information reading/rewriting device, which is another component constituting an RFID system, it is possible to establish noncontact communication. The shape of an RFID tag varies depending on every purpose of use, such as a label type, a card type, a coin type, a stick type, etc. In this regard, see, e.g. Hiromori Arakawa and NTT Data Ubiquitous Workshop, "What's the IC Tag?" published by the Cut System Co., Ltd., pp. 100-101.

US 2005/0199734 discloses an IC card manufacturing method: The antenna coil is produced on the outer surface of a plastic carrier. The chip is placed inside the carrier; the carrier is then filled and sealed with a liquid polymer material. This allows the coil on the card surface to be produced in a simple manner, and it is integrated into the card without the risk of damage. The claims are delimited against this document.

From US 2006/0010685 a manufacturing method of RFID tags is known. Recesses are formed for embedding electronic components on a thermoplastic sheet; the memory chip is then mounted into the recesses, and antenna patterns are formed on the substrate by screen printing. Printing the antenna pattern to the substrate and the connection to the IC chip can be carried out simultaneously. The antenna pattern and a capacity element incorporated in the IC chip form a resonant circuit.

US 2006/0043178 discloses an RFID chip disposed in a recess formed in a non-metallic handle. An antenna pattern in the form of a company label is printed on the surface of the handle.

US 6,027,027 deals with an RFID label consisting of a paper substrate and a paper cover. Between these two layers, an RFID chip is connected to an antenna loop.

In US 2001/0053675 the chip is surrounded by an insulator resin, and the antenna circuit points out of the left and right surface of the resin drop.

An RFID tag conventionally used includes an insulating substrate on which an electrically conductive antenna circuit is formed, over which there is bonded a circuit component, such as an IC (Integrated Circuit) device or the like. Now, considering an environment where an RFID tag is used, if the RFID has a protrusion formed by such a component, the protrusion hay have force fallen on due to scrape or friction caused during handling by grabbing or moving with hands the product carrying the RFID, and thus its surface is desirably formed flat. For this reason, the surface having an IC chip or the like bonded thereon has been coated with an insulator, such as resin or the like, or the surface has been laminated with a film to be smoothened.

However, it has been a problem that coating with resin or lamination with a film in order to manufacture an RFID tag having its surface smoothened causes an increase in number of materials and manufacturing processes. Further, when the surface is laminated with a film for smoothening, although not covering up to the lower part of the component, whereby a gap, or void, may be caused between the component and the insulating substrate so that the void has had an effect of lowering reliability.

Still further, the antenna circuit is also covered with an insulator, such as resin or the like. Thus, when the RFID is used with a high frequency of 900 megahertz (MHz) or more in general, the insulator made of resin or the like is required to have good electric properties, such as low radiation resistance and resistance loss, and matched specific impedance. Further, when coating the component after bonded, the insulator is also required to have its embedding characteristic in a void, i.e, its nature of well filling up the void. It has thus been necessary to use a specific material, such as resin or the like, meeting both of the characteristics simultaneously, i.e. good electric properties and embedding characteristic, or well filling up the void.

Moreover, since the conventional solution is directed to mounting a component on an insulating substrate, there is no other measures than to make the component or the insulating substrate thinner in order to contrive a thin tag.

### SUMMARY OF THE INVENTION

It is therefore an object of the present invention to provide an RFID tag, an RFID system and a method for manufacturing an RF1D tag, capable of fabricating circuitry after covering with an insulating layer a component mounted and bonded on a planar body.

The present invention is defined in the independent claims. The dependent claims define embodiments thereof.

A thin RFID tag may be provided. More specifically, in the RFID tag including a memory medium for storing information, an insulator surrounding the memory medium, and a circuit for transmitting or receiving a radio signals bearing the information, the circuit is fixedly adhered on the insulator in a fashion being exposed out of one surface of the insulator.

An RFID tag includes a memory medium for storing information, an insulator surrounding the memory medium, a circuit for transmitting or receiving a radio signal bearing the information, and an electrically conductive body bonded on a surface of the insulator, the memory medium being fixedly adhered between the circuit and the electrically conductive body.

Further, in accordance with the present invention, a method for manufacturing an RFID tag allows simplification of the manufacturing process. More specifically, the manufacturing method includes the steps of bonding a memory medium for storing information on one face of a plate-like body, fixedly adhering an insulator on the one face of the plate-like body in a fashion surrounding the memory medium, and forming a circuit for transmitting or receiving a radio signal bearing the information on the other face opposite to the one face of the plate-like body.

In accordance with the present invention, as a circuit is formed after an insulator has been fixedly adhered in a fashion surrounding a memory medium mounted and bonded on a plate-like body, it is possible to make an RFID tag thinner. In addition, a manufacturing process of such an RFID tag can be simplified.

### BRIEF DESCRIPTION OF THE DRAWINGS

The objects and features of the present invention will become more apparent from consideration of the following detailed description taken in conjunction with the accompanying drawings in which:
FIG. is a cross-sectional view of an RFID tag of an embodiment in accordance with the present invention, cut in the vertical direction as seen from its front;
FIGS. 2, 3 and 4 exemplarily show, in cross-sectional view, the steps of manufacturing the RFID tag shown in FIG. 1;
FIG. 5 is a schematic diagram of an RFID system including the RFID tag shown in FIG. 1; and
FIG. 6 is a cross-sectional view of a prior art RFID tag, cut in the vertical direction as seen from its front.

### DESCRIPTION OF THE PREFERRED EMBODIMENT

In the following, a preferred embodiment for implementing an RFID tag in accordance with the present invention will be described in detail with reference to the accompanying drawings. The RFID tag 10 in accordance with the embodiment is fabricated into the form of information communication medium having an external appearance in a shape selected according to a specific purpose of use, such as a label shape, a card shape, or the like.

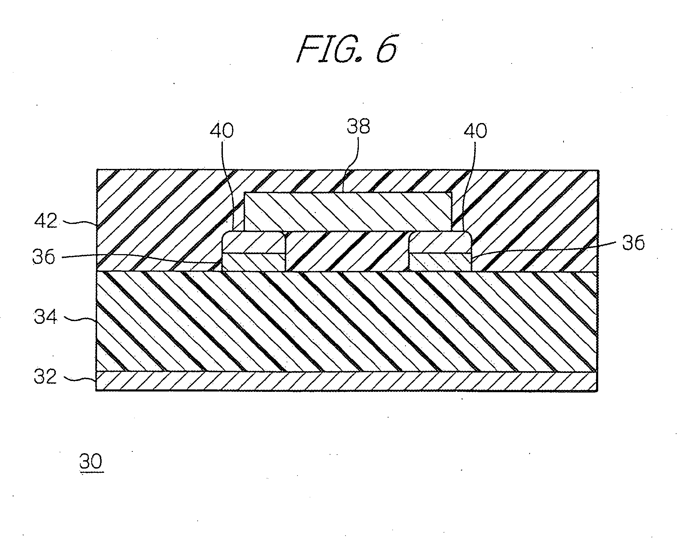

For the purpose of better understanding the invention, a prior art example of RFID tag and its manufacturing method will be described with reference first to FIG. 6 . In the figure, an RFID tag 30 has a substrate insulating layer 34 fixedly adhered on a metal plate 32. On the substrate insulating layer 34, there is formed electrically conductive antenna circuit 36, on which there is bonded a circuit component 38, such as an IC chip or the like, having information stored therein, for example. In fact, FIG. 6 shows some cross sections of the antenna circuit 36 in the prior art tag 30. In order to avoid a protrusion from being caused due to the existence of the component 38, the surface on which the component 38 is bonded is coated with an insulating layer 42, such as resin or the like, so as to flatten its surface.

A common method for manufacturing the RFID tag 30 will be described. On a metal plate 32 prepared, there is fixedly adhered a substrate insulating layer 34, on which there is formed an electrically conductive antenna circuit 36. On the antenna circuit 36, a circuit component 38, such as an IC (semiconductor integrate circuit) chip or the like, is mounted and bonded with solders 40 or by means of supersonic waves, for example. Further, in order to smoothen or make flatten the surface of the bonded circuit 36 to cope with scrape caused during handling, the surface having the component 38 bonded thereon is coated with an insulating layer 42, such as resin or the like, to smoothen the surface after the bonding.

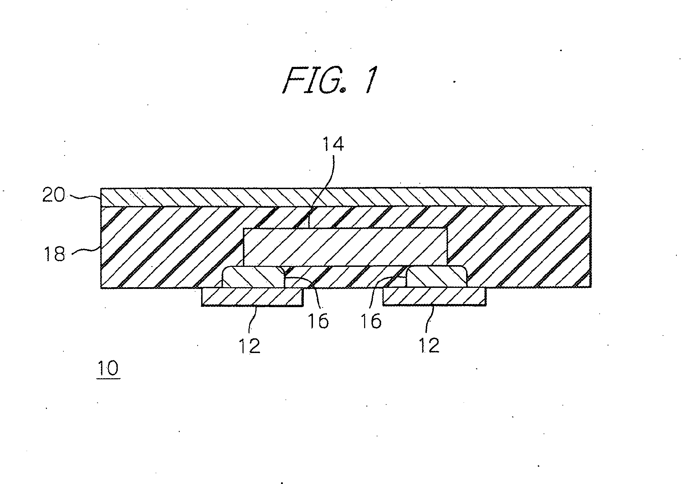

Now, the constitution of an RFID tag 10 of an embodiment in accordance with the present invention will be described. FIG. 1 shows a cross-section cut in the vertical direction viewed from the front, for example in case that the RFID tag in accordance with the embodiment is of a flat planar shape like a card. A antenna circuit 12 for use in transmitting or receiving radio signals bearing information, formed with electrically conductive material is bonded onto an IC chip 14 having predetermined information, such as identifying codes or the like, stored therein via, for example, solder 16 deposited between the circuit 12 and the chip 14. In fact, FIG. 1 shows some cross-sections of the antenna circuit 1 2 in the embodiment. The chip 14 is surrounded with a thermoplastic resin 18 serving as an insulating layer, except for the portions bonded to the circuit 12. The insulating layer 18 constituting the interior of the RFID tag 10 is essentially only the thermoplastic resin 18.

In addition, electrically conductive paste may be used instead of the solder 16. For the electrically conductive paste, silver, copper, copper particles coated with silver, or others may be used as far as it has electrical conductivity.

The antenna circuit 12 is fixedly adhered to the thermoplastic resin 18, which is an insulator having a thermally melting property, more specifically, pressure-bonded. On the other hand, on the surface parallel to, i.e. opposite to the surface having the circuit 12 pressure-bonded thereon there is also pressure-bonded an electrically conductive flat plate-like foil 20, since the RFID tag 10 is preferably of a metal-adaptable type capable of information communication even when it is pasted on a metal. Accordingly, the chip 14 is fixedly adhered between the circuit 12 and the electrically conductive foil 20. To the electrically conductive foil 20, applicable is a metal having good conductivity, for example a copper foil or the like. However, if it is unnecessary to make the RFID tag 10 to be of a metal-adaptable type, the electrically conductive foil 20 may be superfluous.

In this way, since the antenna circuit 12 is arranged to be exposed out of the surface of the thermoplastic resin 18, material as the thermoplastic resin 18 does not necessarily meet both a good embedding characteristic and a good electric characteristic, which leads to easy processing and reduced cost, resulting in a widened range of election of an insulating material according to the situation of every manufacturer.

The RFID tag 10 may be provided with holes appropriately, when electric conduction has to be made between the front and rear faces, i.e. the one face side having the circuit 12 carried thereon and the other face side having the electrically conductive foil 20 provided thereon, or when the RFID tag 10 has to be set on another utility object, such as an object to be identified.

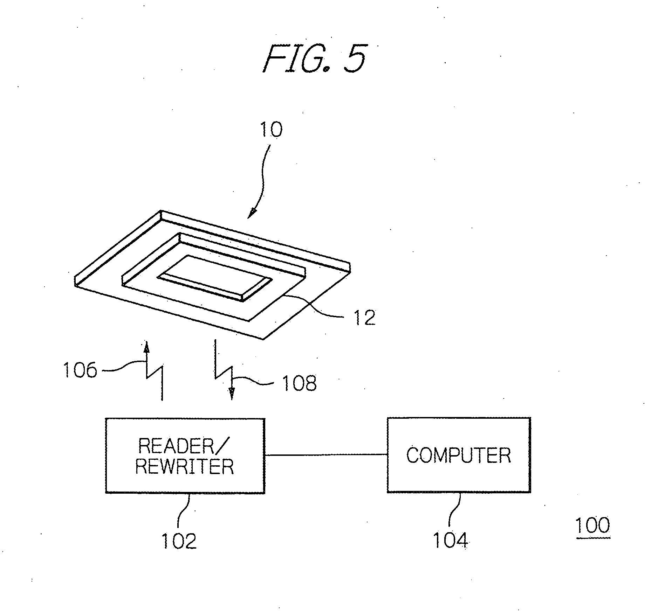

Subsequently, information reading operation in the RFID system 100 using the RFID tag 10 will be described with reference to FIG. 5. A reader 102, which is a device for reading out information stored in the chip 14, is connected to an upper-layer processing system, for example a computer 104, for controlling operation of reading and the like.

When the upper-layer system transmits a command for reading information to the reader 102, the reader 102 generates a radio signal 106, such as a magnetic field or an electro-magnetic wave. In the RFID tag 10, the antenna circuit 12 receives the radio signal generated by the reader, whereby electric current is induced. Further, the RFID tag 10 receives the command for reading information conveyed by the radio signal 106. The received command is interpreted by the circuitry in the IC chip 14 and the stored information is transmitted by means of the radio signal 108 via the circuit 12. The information transmitted by the RFID tag 10 is received in the reader 102, and then, the reader 102 further sends out the information to the upper-layer system. The upper-layer system, such as a computer 104 or the like, collates the received information with a data base, not shown, or the like so as to enable reading and communication of information stored in the chip 14.

Reading of information stored in the chip 14 has been described so far, while rewriting of information is also executed according to the similar principle. Thus, the reader 102 can be a reader/rewriter. Further, in the embodiment, the RFID tag 10 has been described as a passive tag without carrying a battery thereon. However, even in case of an active tag having a battery built therein, there is difference in that it transmits information by itself and not according to a command for reading information, although the fundamental flow of operation may be similar in the other respects.

Under the operation described above, as the antenna circuit 12 adapted for transmitting and receiving information is exposed out of the RFID tag 10, it is possible to transmit and receive radio signals smoothly regardless of how the electric characteristic of the thermoplastic resin 18 constituting the interior of the RFID tag is.

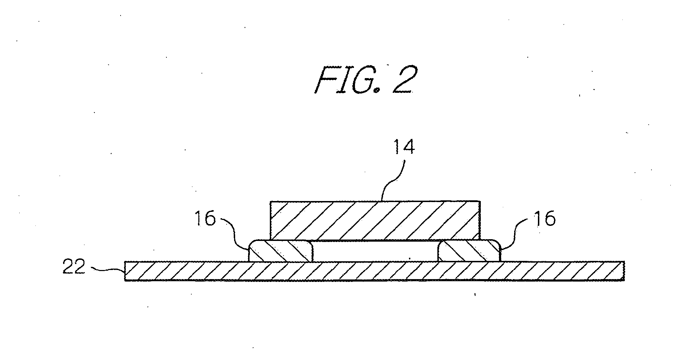

Subsequently, a method for manufacturing the RFID tag 10 will be described in detail with reference to FIGS. 2, 3 and 4. For a plate-like body 22, it is preferable to use electrically conductive foil made of electrically conductive material, for instance copper foil, because it facilitates formation of the antenna circuit 12. When the plate-like body 22 is of electrically conductive material, parts of the plate-like body 22 can form the circuit 12 of the RFID tag 10 at the end, as shown in FIG. 1. When the plate-like body 22 made of electrically conductive material is a copper foil, it does not matter if the thickness is optionally selected, for example, to be 12 micrometers (µm), 18 µm, 35 µm, 70 µm, 105 µm, or more as long as it is able to function as the circuit 12 finally formed.

Further, when particularly thin copper foil is used as the plate-like body 22, for example one having a thickness of 10 µm or below, it is no problem to use such a copper foil provided with a carrier. When the copper foil with a carrier is used, it is possible to eliminate difficulties in the manufacture of the RFID tag 10 due to the plate-like body 22 being extremely thin, since the carrier portion can be peeled off after the copper foil with the resin 18 and the conductive foil 20 has become to be sufficient thickness through a process, which will be described later. As a result, even when an RFID tag 10 pursued for extraordinary thinning is manufactured, it is possible to readily carry on the manufacturing work.

Moreover, the plate-like body 22 preferably has a shiny face formed of a smooth surface on its one side and a matte face formed of somewhat rugged surface on its other side. It is the reason that the adhesiveness after the plate-like body 22 and the thermoplastic resin 18 have been pressure-bonded to each other, which will be described later, is enhanced by an anchor effect brought about due to the existence of the rugged face.

Pasting the plate-like body 22 to a carrying jig facilitates execution of the subsequent work operations and is, thus, desirable in respect of adaptability to mass production. The carrying jig is preferably one made of metal, while it may be a product made of material other than that as far as it is thermally resistant to a reflow temperature of high temperature solder.

The solder 16 is applied on one side of the plate-like body 22. When one side of the body 22 is a shiny surface and the other side of that is a matte one, then the solder 16 may be applied on the matte surface. As for the solder 16 to be applied, one having different composition, such as eutectic solder, lead-free solder or the like, may also be used as well as cream solder. As an applying method, a screen printing method is commonly used, while other methods may be used for application, as a matter of course. When using the screen printing, a carrying jig thermally resistant to a reflow temperature may be used, or when a copper foil with a carrier has been used in the plate-like body 22, solder may be applied on the plate-like body 32 without any carrying jigs.

Then, the chip 14 is mounted in a position on the plate-like body 22 where the solder 16 has been applied, and the manufacturing steps described so far are shown in FIG. 2. When the chip 14 is mounted, it is preferable to use a mounted for mounting the chip, since it facilitates accurate mounting, while it is not limited to mounting with a counter as a matter of course.

Thereafter, the plate-like body 22 having the chip 14 mounted thereon is heated and fused in a solder reflow kiln. As the temperature profile varies depending on the size of the plate-like body 22 and the calorific capacity of a carrying jig, the profile is optionally set. After the temperature rise and the following temperature fall caused by the reflow method, the plate-like body 22 and the chip 14 are bonded to each other via the solder 16.

In addition, it has been described that an electrically conductive paste may also be used instead of the solder 16, in which case, the paste is also applied on the plate-like body 22 by a screen prinking method or the like, and thereafter the chip 14 is mounted. Hardening conditions, such as the hardening time of an electrically conductive paste required for bonding the plate-like body 22 and the chip 14 to each other, follow an electrically conductive paste to be used. Besides the above, it is possible to use carious bonding means, for example ultrasonic bonding and others.

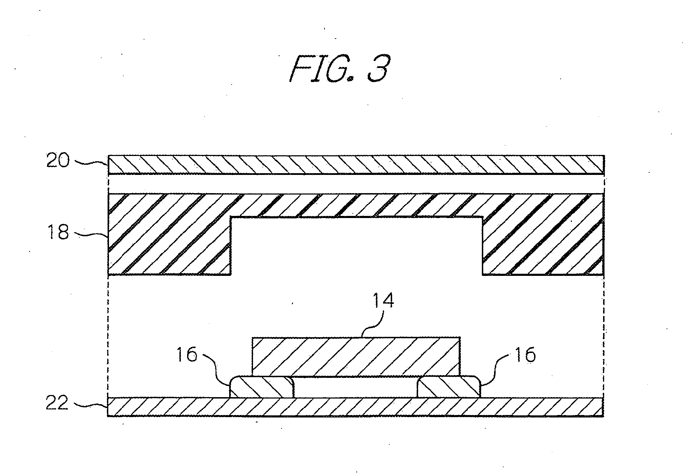

Subsequently, a step for laminating and pressure-bonding the thermoplastic resin 18 and the electrically conductive foil 20 on the plate-like body 22 having the chip 14 mounted thereon will be described with reference to FIG. 3. The thermoplastic resin 18 is laminated on the side of the plate-like body 22 having the chip 14 mounted thereon, and further the electrically conductive foil 20 is laminated on the surface of the thermoplastic resin 18. In other words, positional relation is formed in such a way that the thermoplastic resin 18 is interposed between the plate-like body 22 and the electrically conductive foil 20. At this instant, the face out of the electrically conductive foil 20 brought in contact with the thermoplastic resin 18 is preferably a matte surface. It is the reason that the adhesiveness, after the electrically conductive foil 20 and the thermoplastic resin 18 have been pressure-bonded to each other, is enhanced by an anchor effect brought about by the existence of the rugged face.

After the thermoplastic resin 18 has been hardened again through heating, it comes to have volume, in particular a thickness, sufficient to surround at least the chip 14. At this instance, in view of convenience in operation, the face out of the thermoplastic resin 18 brought in contact with the plate-like body 22 at the time of being laminated is hollowed beforehand by an optional method, such as drilling, laser processing, or the like, so as to be fitted to a protruded portion of the plate-like body 22 caused due to mounting of the chip 14. More specifically, it is preferable to carry out hollowing in conformity to the height obtained by adding a clearance (void) produced between the chip 14 and the plate-like body 22 to the thickness of the chip 14 as well as in conformity to the length and the width of the protruded portion in such a way that the thermoplastic resin 18, when being laminated on the body 22 having the chip 14 mounted thereon, engages with the body 22. It is the reason that the position on which the thermoplastic resin 18 is laminated is stabilized, which facilitates the subsequent manufacturing works.

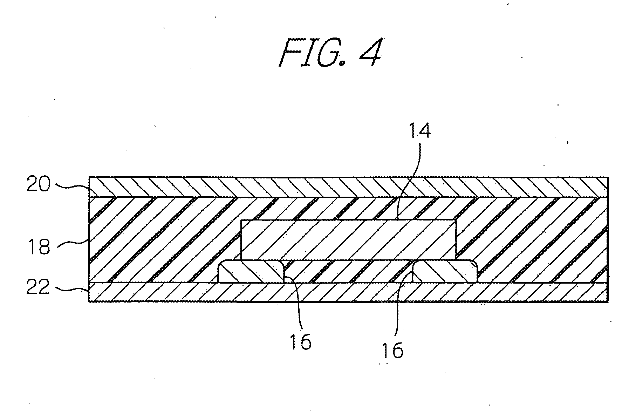

The thermoplastic resin 18 and the electrically conductive foil 20 have been laminated on the plate-like body 22, and thereafter heating and pressurization are carried out. The thermoplastic resin 18 starts melting by heating, and further, the plate-like body 22 having the chip 14 mounted thereon and the resin 18 are pressure-bonded to each other as well as the resin 18 and the electrically conductive foil 20 are done so. By being subject to the above process, when the thermoplastic resin 18 is hardened again, the chip 14 is finally settled in a fashion being surrounded with the resin 18. The RFID tag 10 in this step is shown in FIG. 4. In addition, in order to fill the resin into the void formed between the mounted chip 14 and the plate-like body 22, heating and pressure-bonding are preferably carried out under vacuum.

In this way, as the chip 14 is settled in a state of being surround essentially only with the thermoplastic resin 18, the chip 14 can be thinned by the height of the component. Further, there is no need of a step for smoothening the surface of the plate-like body 22 having the chip 14 bonded thereon.

Adhesion of the thermoplastic resin 18 to the plate-like body 22 having the chip 14 mounted thereon is possible also by a known method other than the method described above. Further, if it is unnecessary for the RFID tag 10 to be of metal-adaptable type, adhesion of the thermoplastic resin 18 to the plate-like body 22 having the chip 14 mounted thereon may be carried out by using other plate-like body instead of the electrically conductive foil 20, or without using other plate-like body.

When a hole for conduction or setting has to be drilled in the RFID tag 10, the drilling is carried out after the completion of heating and pressure-bonding. In such a case, the hole is drilled by an appropriate method, such as drilling or laser processing. When the hole is intended for electric conduction between the front and rear sides, electrolytic plating is additionally carried out after nonelectrolytic plating has been applied to the lateral face of the hole. It preferable to employ a wet method in nonelectrolytic plating for depositing plating on the lateral face of the hole, while a dry method may be employed, as matter of course, such as vacuum deposition, spattering, ion plating, or the like. In addition, in a wet method, it is most preferable to use Pd catalyst solution having good liquid stability, prolonged service life and excellence in respect of the cost, while other catalyst solution may be used, as a matter of course.

Subsequently, the antenna circuit 12 is formed on the other side of the plate-like body 22 opposite to the side on which the thermoplastic resin 18 has been pressure-bonded. For formation of the circuit it is preferable to depend on a process, in which a dry film resist is laminated on the surface of the plate-like body 22, which is an electrically conductive foil such as copper foil, to implement exposure and development, and further, part of the plate-like body 22 left unremoved after etching is formed into the circuit 12, since it is the easiest and most inexpensive way. The antenna circuit 12 in FIG. 1 has been formed from part of the plate-like body 22 in the above method. However, even though the plate-like body 22 is an insulator, the circuit 12 maybe formed by other known processes, such as an additive method for forming the circuit on the plate-like body 22 by plating, a method for printing an electrically conductive paste and the like.

As described above, by using a manufacturing method in which the antenna circuit 12 is arranged to be exposed outside of the thermoplastic resin 18, material as the thermoplastic resin 18 does not necessarily meet the requirement for a good embedding and electrical characteristic, which leads to easy processing and inexpensive cost, resulting in a widened range of selecting material according to a situation of each manufacturer. Further, as the antenna circuit 12 is formed after the chip 14 has been mounted first on the plate-like body 22 and then the thermoplastic resin 18 has been pressure-bonded on the body 22, there is no need of a conventional process for flattening after mounting the chip 14 on the formed circuit 12, which enables efficient manufacture of the RFID tag 10.

Finally, the RFID tag 10 is processed into a desired shape and formed. In the forming process, an appropriate processing technique can be used, such as a router, a press, a laser, dicing, or the like. The RFID tag thus formed is used together with a known reading/rewriting device, which is a device for reading and rewriting information stored in the chip 14, whereby it is possible to execute noncontact communication of information, and thus, the RFID tag 10 constitutes a part of the RFID system.

### Example 1

As a plate-like body 22, copper foil having a thickness of 18µm made by Furukawa Circuit Foil Co., Ltd., was used. The copper foil as the plate-like body 22 has a shiny surface and a matte surface and is an unused product treated with anti-oxidization.

The shiny face side of the copper foil, which is the plate-like body 22 was pasted on a carrying jig, while the matte face side was coated with solder 16 thereon by screen printing. The solder 16 used on this occasion was lead-free solder M705-235C-21 manufactured by Senju Metal Industry Co., Ltd.

An IC chip 14 was mounted on the coated solder 16 with a mounter and heated to be fused in a solder reflow kiln. At this instance, the reflow profiting was executed with residual heat at 180 degrees Celsius for 120 seconds and peak temperature of 240 degrees Celsius for 10 seconds.

As a thermoplastic resin 18 which is an insulating layer, ER140 manufactured by Nippon Oil and Fats Co., Ltd., was used. One face of the thermoplastic resin 18 was hollowed with a drill so as to meet the shape of a protruded portion of the plate-like body 22 caused due to mounting of the chip 14. Then, the thermoplastic resin 18 was laminated on the plate-like body 22 in such a way that the portion hollowed with the drill and the protruded portion of the body 22 engaged with each other, and further the copper foil having a matte surface was laminated as an electrically conductive foil 20 on the thermoplastic resin 18 in such a way that the matte surface was brought in contact with the resin 18. Thereafter, heating and pressure-bonding were executed under vacuum.

After the completion of pressure-bonding, in order to form conductive pathways, both copper foils on the side of the plate-like body 22 and on the side of the electrically conductive foil 20 between which the thermoplastic resin 18 was interposed were drilled holes therein with a laser, nonelectrolytically plated using Pd catalytic solution, and further electrolytically plated.

After the completion of plating, a portion of the copper foil surface on the side of the plate-like body 22, except for a portion on which antenna circuit 12 was intended to be formed, was laminated with a dry film resist AQ-2558 manufactured by Asahi Kasei EMD Corporation. Thereafter, by executing exposure, development and etching of the copper, portions of the copper foil having the dry film resist not laminated were remained in a state of being pressure-bonded with the thermoplastic resin 18 to form the circuit 12.

### Example 2

Next, an RFID tag according to another example of the present invention will now be described. A basic manufacturing method is similar to that in the foregoing example except that in the process for mounting the IC chip 14 on the copper foil, which is the plate-like body 22, an electrically conductive copper paste AE3030 manufactured by Tatsuta System Electronics Co., Ltd., was used as the solder 16, instead of the lead-free solder M705-235C-21 made by Senju Metal Industry Co., Ltd., to coat the plate-like body 22 (the copper foil of 18 µm thick manufactured by Furukawa Circuit Foil Co., Ltd.) by screen printing.

An RFID reader in the RFID tag 10 manufactured through the processes described above, like that in the RFID tag 10 manufactured by the foregoing example using a lead-free solder, can also normally identify information stored in the IC chip 14.

## Claims

1. A radio frequency identification (RFID) tag (10) comprising:
a memory medium (14) for storing information;
an insulator (18) having a volume sufficient to surround said memory medium (14); and
a circuit (12) for transmitting or receiving a radio signal bearing the information,
wherein said circuit (12) is fixedly adhered on said insulator (18) in a fashion being substantially exposed on one surface of said insulator (18),
**CHARACTERIZED BY** comprising an electrically conductive body (20) bonded on a surface of said insulator (18) on the opposite side of the surface exposing the circuit (12),
said memory medium (14) being fixedly adhered between said circuit (12) and said electrically conductive body (20).

2. The RFID tag as claimed in claim 1, **CHARACTERIZED IN THAT** said insulator (18) is a thermoplastic resin.

3. A radio frequency identification (RFID) system comprising: the RFID tag (10) as claimed in claim 1 or 2; and a reader/rewriter for performing at least either of reading and rewriting of the information stored in said memory medium (14).

4. A method for manufacturing a radio frequency identification (RFID) tag, **CHARACTERIZED BY** comprising the steps of:
bonding a memory medium (14) for storing information on one face of a plate-like body (22);
fixedly adhering an insulator (18) on the one face of the plate-like body (22), said insulator (18) having a volume sufficient to surround the memory medium (14); and
forming a circuit (12) for transmitting or receiving a radio signal bearing the information on the other face opposite to the one face of the plate-like body (22) so that the circuit is exposed on a surface of the insulator (18),
wherein material of the plate-like body (22) is an electrically conductive body, and part of the plate-like body is formed into the circuit (12).

5. The method as claimed in claim 4, **CHARACTERIZED IN THAT** the insulator (18) is a thermoplastic resin.

6. The method as claimed in claim 4 or 5, **CHARACTERIZED IN THAT** said step of fixedly adhering the insulator (18) includes:
a substep of cutting one side of the insulator (18) in such a way that the one face of the plate-like body (22) and the insulator (18) engage with each other; and
laminating the insulator (18) onto the one face of the plate-like body (22).

## Patentansprüche

1. Funkfrequenz-Identifikations (RFID)-Etikett (10), umfassend:
ein Speichermedium (14) zum Speichern von Information;
einen Isolator (18), welcher ein Volumen aufweist, das ausreicht, um das Speichermedium (14) zu umgeben; und
eine Schaltung (12) zum Senden oder Empfangen eines Funksignals, welches die Information trägt,
wobei die Schaltung (12) an den Isolator (18) in einer Art und Weise fest gebunden ist, dass sie im Wesentlichen auf einer Oberfläche von dem Isolator (18) freiliegt,
**dadurch gekennzeichnet, dass** es einen elektrisch leitenden Körper (20) umfasst, welcher an eine Oberfläche von dem Isolator (18) auf der gegenüber liegenden Seite von der Oberfläche, auf der die Schaltung (12) freiliegt, gebondet ist,
wobei das Speichermedium (14) fest zwischen der Schaltung (12) und dem elektrisch leitenden Körper (20) gebunden ist.

2. RFID-Etikett nach Anspruch 1, **dadurch gekennzeichnet, dass** der Isolator (18) ein thermoplastisches Harz ist.

3. Funkfrequenz-Identifkations (RFID)-System, umfassend: das RFID-Etikett (10) nach Anspruch 1 oder 2; und einen Leser/Rückschreiber zum Durchführen des Lesens und/oder Rück-Schreibens der Information, die in dem Speichermedium (14) gespeichert ist.

4. Verfahren zum Herstellen eines Funkfrequenz-Identifikations (RFID)-Etiketts, **dadurch gekennzeichnet, dass** es die Schritte umfaßt:
Bonden eines Speichermediums (14) zum Speichern von Information an eine Fläche eines tellerartigen Körpers (22);
festes Binden eines Isolators (18) an die eine Fläche von dem tellerartigen Körper (22), wobei der Isolator (18) ein Volumen aufweist, das ausreicht, um das Speichermedium (14) zu umgeben; und
Bilden einer Schaltung (12) zum Senden oder Empfangen eines Funksignals, welches die Information trägt, auf der anderen Fläche, die der einen Fläche gegenüber liegt, von dem tellerartigen Körper (22) derart, dass die Schaltung auf einer Oberfläche von dem Isolator (18) freiliegt,
wobei ein Material von dem tellerartigen Körper (22) ein elektrisch leitender Körper ist und wobei ein Teil von dem tellerartigen Körper in der Schaltung (12) gebildet wird.

5. Verfahren nach Anspruch 4, **dadurch gekennzeichnet, dass** der Isolator (18) ein thermoplastisches Harz ist.

6. Verfahren nach Anspruch 4 oder 5, **dadurch gekennzeichnet, dass** der Schritt des festen Bindens des Isolators (18) enthält:
einen Unterschritt des Schneidens von einer Seite des Isolators (18) in einer solchen Weise, dass die eine Fläche von dem tellerartigen Körper (22) und der Isolator (18) miteinander in Eingriff sind; und
Laminieren des Isolators (18) auf der einen Fläche von dem tellerartigen Körper (22).

## Revendications

1. étiquette (10) d'identification par radiofréquence (RFID) comprenant :
un support mémoire (14) pour stocker des informations ;
un isolant (18) ayant un volume suffisant pour entourer ledit support mémoire (14) ; et
un circuit (12) pour transmettre ou recevoir un signal radio portant les informations,
dans lequel ledit circuit (12) est fixé à demeure audit isolant (18) de façon à être sensiblement exposé sur une surface dudit isolant (18),
**caractérisé en ce qu'**elle comprend un corps électriquement conducteur (20) lié sur une surface dudit isolant (18) sur le côté opposé de la surface exposant ledit circuit (12),
ledit support mémoire (14) étant fixé à demeure entre ledit circuit (12) et ledit corps électriquement conducteur (20).

2. Etiquette RFID selon la revendication 1, **caractérisé en ce que** ledit isolant (18) est une résine thermoplastique.

3. Système d'identification par radiofréquence (RFID) comprenant : l'étiquette RFID (10) selon la revendication 1 ou 2 ; et un lecteur/graveur pour réaliser au moins l'une ou l'autre de la lecture ou de
la réécriture des informations stockées dans ledit support mémoire (14).

4. Procédé de fabrication d'une étiquette d'identification par radiofréquence (RFID), **caractérisé en ce qu'**il comprend les étapes suivantes :
la liaison d'un support mémoire (14) pour stocker des informations sur une face d'un corps de type plaque (22) ;
la fixation à demeure d'un isolant (18) sur ladite face dudit corps de type plaque (22), ledit isolant (18) ayant un volume suffisant pour entourer le support mémoire (14) ; et
la formation d'un circuit (12) pour transmettre ou recevoir un signal radio porteur des informations sur l'autre face opposée à ladite face dudit corps de type plaque (22) de sorte que le circuit est exposé sur une face de l'isolant (18),
dans lequel le matériau du corps de type plaque (22) est un corps électriquement conducteur, et une partie du corps de type plaque est formée dans le circuit (12).

5. Procédé selon la revendication 4, **caractérisé en ce que** l'isolant (18) est une résine thermoplastique.

6. Procédé selon la revendication 4 ou 5, **caractérisé en ce que** ladite étape de fixation à demeure de l'isolant (18) comporte :
une sous-étape de découpe d'un côté de l'isolant (18) de telle manière que ladite face du corps de type plaque (22) et l'isolant (18) se mettent en prise l'un avec l'autre ; et
la stratification de l'isolant (18) sur ladite face du corps de type plaque (22).
